# EUROPÄISCHE PATENTSCHRIFT

(11) **EP 1 389 404 B1**
(45) Veröffentlichungstag und Bekanntmachung des Hinweises auf die Patenterteilung: **18.08.2004**
(21) Anmeldenummer: 02742782.2
(22) Anmeldetag: 17.05.2002
(51) Int. Cl.: H05K 1/02, H05K 9/00

(54) **VERFAHREN ZUR ABSCHIRMUNG EINER AUF EINER LEITERPLATTE REALISIERTEN ELEKTRISCHEN SCHALTUNG UND EINE ENTSPRECHENDE KOMBINATION EINER LEITERPLATTE MIT EINER ABSCHIRMUNG**
METHOD FOR SHIELDING AN ELECTRIC CIRCUIT CREATED ON A PRINTED CIRCUIT BOARD AND A CORRESPONDING COMBINATION OF A PRINTED CIRCUIT BOARD AND A SHIELD
PROCEDE POUR LE BLINDAGE D'UN CIRCUIT ELECTRIQUE REALISE SUR UNE CARTE A CIRCUITS IMPRIMES ET COMBINAISON CORRESPONDANTE D'UNE CARTE A CIRCUITS IMPRIMES AVEC UN BLINDAGE

(30) Priorität: 21.05.2001 DE 10125746
(43) Veröffentlichungstag der Anmeldung: 18.02.2004
(73) Patentinhaber: SIEMENS AKTIENGESELLSCHAFT, 80333 München (DE)
(72) Erfinder: ROMAHN, Joerg, 12353 Berlin (DE)
(86) Internationale Anmeldenummer: PCT/DE2002/001883
(87) Internationale Veröffentlichungsnummer: WO 2002/096164

(56) Entgegenhaltungen:
- WO-A-97/23952
- US-A- 5 783 868

## Beschreibung

Verfahren zur Abschirmung einer auf einer Leiterplatte realisierten elektrischen Schaltung und eine entsprechende Kombination einer Leiterplatte mit einer Abschirmung

Die Erfindung bezieht sich auf ein Verfahren zur Abschirmung einer auf einer Leiterplatte realisierten elektrischen Schaltung. Elemente, die zur Abschirmung von elektrischen, hochfrequenten, abstrahlenden Schaltungen dienen, sind im Allgemeinen aus metallischen Materialien, welche zum Beispiel aufgelötet werden. Alternativ könnte man auch metallisierte Kunststoffgehäuse einsetzen. Diese werden über Dispensstreifen auf der Leiterplatte aufgebracht bzw. kontaktiert. Allerdings sind diese Kunststoffgehäuse aufgrund der Fertigung meist teurer, weshalb sie hier nur wenig Einsatz finden. Ferner weisen die bislang verwendeten Abschirmelemente eine recht formstabile Geometrie auf. Sie bilden eine Art formfestes Gehäuse. Bei einer auf einer Leiterplatte realisierten elektrischen Schaltung sind meist verschieden hohe Bauelemente vorhanden. Bei einer metallischen Abschirmung ist darauf zu achten, dass alle Bauelemente einen ausreichenden Abstand zur metallischen Abschirmung haben, um einen Kurzschluss zu vermeiden. Alternativ könnte eine isolierende Zwischenlage eingebracht werden. Das zur Abschirmung dienende Gehäuse ist von daher derart geformt, dass auch nach seinem Aufsetzen auf die Schaltung ein zusätzlicher Sicherheitsabstand zwischen dem Gehäuse und den einzelnen Bauelementen gewährleistet ist.

Bisher gibt es im wesentlichen zwei grundlegende Ausführungsformen einer Abschirmung. Zum einen ist eine Abschirmung häufig in Form einer Haube ausgeführt, die über die abzuschirmende elektrische Schaltung gestülpt wird. Diese Haube wird im Allgemeinen mittels Schrauben auf der Leiterplatte fixiert. Alternativ dazu kann sie auch auf die Leiterplatte aufgelötet werden. Ein Nachteil dieser Ausführungsform besteht darin, dass diese Haube erst nach Prüfung der Funktionsfähigkeit der elektrischen Schaltung aufgesetzt werden kann. Durch eventuell auftretende mechanische Belastungen bei einer Fixierung mittels Schrauben oder durch thermische Belastungen beim Auflöten ist stets die Gefahr gegeben, dass die elektrische Schaltung einen Schaden erleidet. Eine zweite Ausführungsmöglichkeit einer Abschirmung bietet das Vorsehen eines auf die Leiterplatte aufgelöteten Rahmens, der nach dem Prüfen der Funktionsfähigkeit der elektrischen Schaltung mit einem geeigneten Deckel verschlossen wird. Gegenüber der zuerst vorgestellten Variante zeigt diese Ausführungsmöglichkeit den Vorteil, dass die elektrische Schaltung im Falle einer Reparatur recht einfach durch Abnehmen des Deckels zugänglich ist. Ein Nachteil ergibt sich dabei allerdings durch die daraus eventuell resultierende unzufriedenstellende Befestigung des Deckels, der unter Berücksichtigung einer leichten Abnahmefähigkeit gegebenenfalls auch unkontrolliert bzw. unbeabsichtigt abfallen bzw. sich lösen kann.

Derartige Abschirmungen werden beispielsweise für Technologien wie DECT, GSM sowie auch bei sonstigen Schaltungen im Basisband angewendet. Ferner werden sie auch für Schaltungsteile der Hochfrequenz angewendet.

Ein Nachteil der erläuterten Ausführungsbeispiele von Abschirmungen für elektrische Leitungen ist dadurch gegeben, dass die Abschirmung, wie bereits kurz erwähnt, über das höchste Bauteil der abzuschirmenden elektrischen Schaltung mit einem ausreichenden Sicherheitsabstand angeordnet werden muss, um mögliche Kurzschlüsse zu elektrisch leitenden Bauelementanschlüssen zu vermeiden. Der notwendige Sicherheitsabstand beträgt im Allgemeinen mehrere 1/10 mm, mindestens aber 0,2 mm. Neben dem geeigneten Sicherheitsabstand ist dabei ferner die formstabile Ausführung der Abschirmung wichtig, um bei der Handhabung die Abschirmung nicht zu verformen, sei es zu verbiegen oder zu verbeulen. Bei Verwendung einer Haube ist dabei ferner zu berücksichtigen, dass die Haube eine Toleranz von bis zu 0,5 mm haben kann.

Ein weiterer Nachteil ist bei den bekannten und hier erwähnten Ausführungsbeispielen von Abschirmungen darin zu sehen, dass sich bei starken Temperaturschwankungen mechanische Spannungen ergeben können. Diese Spannungen wiederum wirken auf die Leiterplatte und beanspruchen dabei möglicherweise beispielsweise die Lötanschlüsse. Insofern fallen hier reparaturanfällige Stellen an. Ferner besteht die Gefahr, dass es bei einem schnellen Temperaturanstieg zum Niederschlag von Kondensfeuchtigkeit auf der elektrischen Schaltung und auf der Abschirmung kommen kann, was insbesondere bei hochohmigen elektrischen Schaltungen zu Fehlfunktionen bis hin zum Totalausfall der elektrischen Schaltung führen kann. Es kann aufgrund auftretender Feuchtigkeit zu Kurzschlüssen kommen.

Es war eine Aufgabe der Erfindung ein Verfahren zur Abschirmung einer auf einer Leiterplatte realisierten Schaltung bereitzustellen, mit dessen Hilfe einfach und schnell oben genannte Nachteile der bisher verwendeten Abschirmungen umgangen werden können.

Gelöst wird diese Aufgabe durch den unabhängigen Anspruch 1. Weitere vorteilhafte Ausführungsformen des erfindungsgemäßen Verfahrens sind in den entsprechenden Unteransprüchen aufgeführt.

Gemäß Anspruch 1 wird ein Verfahren zur Abschirmung einer auf einer Leiterplatte realisierten elektrischen Schaltung mit einer Anzahl von Bauelementen bereitgestellt, wobei auf der Leiterplatte eine erste, elektrisch isolierende Schicht vollflächig aufgebracht wird und auf der ersten, elektrisch isolierenden Schicht eine zweite, auf Masse liegende, elektrisch leitende, abschirmend wirkende Schicht derart vollflächig aufgebracht wird, dass entsprechend der Anzahl von Bauelementen geeignete Aussparungen vorgesehen werden.

In einer besonders bevorzugten Ausführungsform des erfindungsgemäßen Verfahrens handelt es sich bei der Kombination der ersten, elektrisch isolierenden Schicht mit der zweiten, auf Masse liegenden, elektrisch leitenden Schicht, wobei die zweite Schicht entsprechende Aussparungen für die Bauelemente aufweist, um eine HDI-Schicht. HDI bedeutet hierbei "High Density Interconnection". Es handelt sich dabei im Allgemeinen um eine Leiterplatte, auf der eine größtmögliche Anzahl von Verbindungswegen realisiert ist. Die elektrisch leitende Schicht besteht im Allgemeinen aus Kupfer und hat eine Dicke im Bereich von 20 µm - 60 µm, vorzugsweise etwa 30 µm. Die elektrisch isolierende Schicht besteht vorzugsweise aus einem Epoxy-Harz und hat eine Dicke im Bereich von 20 µm - 60 µm, vorzugsweise etwa 40 µm. Es ergibt sich somit eine Gesamtdicke im Bereich von 40 µm - 110 µm, vorzugsweise von 40 µm-80 µm.

Der wesentliche Vorteil des erfindungsgemäßen Verfahrens ist darin zu sehen, dass auf eine Abschirmung in Form eines formstabilen Gehäuses, wie beispielsweise eine eingangs beschriebene Haube oder ein Rahmen mit Deckel, verzichtet werden kann. Durch die Miniaturisierung der Bauelemente sowie dem Einsatz von sehr kurzen Anschlüssen, insbesondere von sogenannten "Ballgrids", an den Integrierten Bauelementen kann eine ausreichende Abschirmung einer derartig auf der Leiterplatte realisierten elektrischen Schaltung bereits durch das erfindungsgemäße Verfahren erzielt werden. Dabei ist zu betonen, dass die abzuschirmenden Elemente der elektrischen Schaltung vorwiegend die Anschlussleitungen und weniger die Bauelemente selbst sind. Letztere haben nur eine meist vernachlässigbare Abstrahleffizienz. Die Anschlussleitungen hingegen wirken als Antennen. Von daher müssen die Bauelemente selbst nicht notwendigerweise unmittelbar abgeschirmt werden.

Durch das erfindungsgemäße Verfahren wird die Handhabung der Leiterplatte mitsamt der auf ihr realisierten Schaltung wesentlich einfacher. Die Abschirmung in Form der zwei zusätzlich aufgebrachten Schichten ist quasi voll integriert in die Leiterplatte, so dass kein zusätzlicher Platz für eine Abschirmung in Anspruch genommen werden muss. Bei Verwendung formstabiler metallischer Abschirmungen musste demgegenüber stets ein ausreichender Sicherheitsabstand zu der elektrischen Schaltung bzw. zu den einzelnen, die Schaltung aufbauenden Bauelementen eingehalten werden, um das Auftreten von Kurzschlüssen zu vermeiden. Bislang musste auch bei der Handhabung der Leiterplatte mitsamt der Abschirmung stets darauf geachtet werden, dass es zu keiner Verformung der Abschirmung kommt, die gegebenenfalls das Auftreten von Kurzschlüssen nach sich ziehen konnte. Diese vorsichtige Handhabung ist nach dem erfindungsgemäßen Verfahren nicht mehr nötig.

Die Kontaktierung der einzelnen Bauelemente mit der Leiterplatte zur eigentlichen Vernetzung der einzelnen Bauelemente untereinander erfolgt vorzugsweise mittels einer Laserkontaktierung bzw. Lasertechnik, vorzugsweise unmittelbar am Ort des entsprechenden Bauelementes. Unmittelbar am Ort des Bauelementes bedeutet dabei, dass die Kontaktstellen des Bauelementes vorzugsweise zwischen ihm und der Leiterplatte angeordnet sind. Mittels eines Lasers werden sogenannte Microvias erzeugt. Es handelt sich dabei um sogenannte "Sacklöcher", d.h. um Bohrungen, die eine äußerst geringe Tiefe aufweisen. Die zur Kontaktherstellung notwendigen Bohrungen sind quasi punktuell, so dass sich kein Luftraum in den Bohrungen ergeben kann. Somit entsteht keine Kapillarwirkung. Beim Kontaktieren mittels eines Lötprozesses beispielsweise ist somit gewährleistet, dass das aufgebrachte Lötzinn nicht durch eine auftretende Kapillarwirkung weggezogen oder durch vorhandene Luft weggeschleudert wird. Man erhält so sehr feste und stabile Kontaktstellen.

Die zweite auf Masse liegende, elektrisch leitende, abschirmend wirkende Schicht wird erfindungsgemäß derart vollflächig aufgebracht, dass entsprechend der Anzahl von Bauelementen geeignete Aussparungen vorgesehen werden. Dadurch dass die Kontaktierung der einzelnen Bauelemente mit der Leiterplatte, wie beschrieben, unmittelbar am Ort der jeweiligen Bauelemente vorgenommen werden kann, werden die notwendigen Aussparungen vorzugsweise möglichst klein gehalten, so dass sich eine möglichst große Abschirmung ergibt.

Ein weiterer Vorteil der vorliegenden Erfindung ist darin zu sehen, dass eine wesentlich kleinere Bauform realisiert werden kann, da zusätzlich Flächen für die Aufbringung einer Abschirmung, wie beispielsweise in Form eines Rahmens mit Deckel oder einer Haube, nicht benötigt werden. Durch die Einsparung der Abschirmteile und die verringerte Fläche der Leiterplatte ergibt sich eine positive Bilanz der Kosten.

Ferner umfasst die Erfindung eine Kombination einer Leiterplatte, auf der mindestens eine elektrische Schaltung mit einer Anzahl von Bauelementen realisiert ist, mit einer ersten, elektrisch isolierenden Schicht und einer zweiten, auf Masse liegenden, vollflächigen, elektrisch leitenden, abschirmend wirkenden Schicht, wobei die erste, elektrisch isolierende Schicht vollflächig auf der Leiterplatte aufgebracht ist und auf der ersten, elektrisch isolierenden Schicht die zweite, auf Masse liegende, elektrisch leitende, abschirmend wirkende Schicht derart vollflächig aufgebracht ist, dass entsprechend der Anzahl von Bauelementen geeignete Aussparungen vorgesehen sind.

Vorzugsweise handelt es sich bei der Kombination der ersten, elektrisch isolierenden Schicht mit der zweiten, auf Masse liegenden, vollflächigen, elektrisch leitenden Schicht um eine HDI-Schicht. HDI steht für "high density interconnection".

Die Kontaktierung der einzelnen Bauelemente mit der Leiterplatte zur eigentlichen Vernetzung der einzelnen Bauelemente untereinander ist vorzugsweise mittels einer Laserkontaktierung, vorzugsweise unmittelbar am Ort des entsprechenden Bauelementes realisiert. Unmittelbar am Ort des Bauelementes bedeutet dabei, dass die Kontaktstellen des Bauelementes vorzugsweise zwischen ihm und der Leiterplatte angeordnet sind. Dadurch wird es möglich die in der zweiten, auf Masse liegenden elektrisch leitenden Schicht vorgesehenen Aussparungen für die entsprechende Anzahl von Bauelementen hinsichtlich ihrer jeweiligen Abmessungen möglichst klein zu halten, so dass eine optimale Abschirmung erzielt wird.

Weitere Vorteile der vorliegenden Erfindung werden anhand der nachfolgenden Figur dargelegt. Es zeigt:

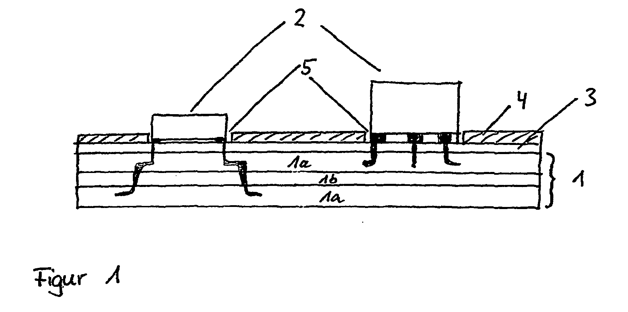

Fig. 1 Schematische Darstellung einer Kombination einer Leiterplatte, auf der mindestens eine elektrische Schaltung mit einer Anzahl von Bauelementen realisiert ist, mit einer ersten, elektrisch isolierenden Schicht und einer zweiten, auf Masse liegenden, vollflächigen, elektrisch leitenden Schicht.

Figur 1 zeigt eine Kombination einer Leiterplatte 1, auf der eine elektrische Schaltung mit einer Anzahl von Bauelementen 2 realisiert ist. Auf der Leiterplatte 1 ist eine erste elektrisch isolierende Schicht 3 vollflächig aufgebracht, d.h. diese Schicht 3 erstreckt sich über die gesamte Fläche der Leiterplatte 1. Vorzugsweise besteht die Schicht 3 aus einem Epoxy-Harz und weist eine Dicke im Bereich von 20 µm-60 µm, vorzugsweise von etwa 40 µm auf. Auf dieser ersten Schicht 3 ist eine zweite, auf Masse liegende, elektrisch leitende Schicht 4 aufgebracht. Die Schicht 4 weist entsprechend der Anzahl der Bauelemente 2 Aussparungen 5 auf. Die Schicht 4 ist vorzugsweise aus Kupfer. Die Kontaktierung der Bauelemente 2 mit der Leiterplatte 1 ist unmittelbar am Ort der jeweiligen Bauelemente 2 vorgenommen, so dass die zweite, auf Masse liegende, elektrisch leitende Schicht 4 sehr nahe an die einzelnen Bauelemente 2 heranreichen kann bzw. die Aussparungen 5 hinsichtlich ihrer Abmessungen sehr gering gehalten werden können. Demnach ist eine möglichst breitflächige Abschirmung mittels der zweiten, auf Masse liegenden, elektrisch leitenden Schicht 4 erreicht. Wie bereits beschrieben werden die Bauelemente 2 vorzugsweise mittels einer Lasertechnik mit der Leiterplatte kontaktiert. Mit Hilfe der Lasertechnik werden sogenannte Microvias, d. h. "Sacklöcher" erzeugt. Es handelt sich dabei um Bohrungen, die eine äußerst geringe Tiefe haben.

Die Leiterplatte 1 selbst besteht hier ebenfalls aus mehreren Schichten, wobei sich elektrisch leitende Schichten 1a und elektrisch isolierende Schichten 1b abwechseln. Vorzugsweise bestehen die elektrisch leitenden Schichten 1a aus Kupfer, während die elektrisch isolierenden Schichten 1b aus einem Epoxy-Harz bestehen. Die eigentliche Vernetzung der einzelnen Bauelemente 2 findet in den elektrisch leitenden Schichten 1a der Leiterplatte 1 statt.

## Patentansprüche

1. Verfahren zur Abschirmung einer auf einer Leiterplatte (1) realisierten elektrischen Schaltung mit einer Anzahl von Bauelementen (2), wobei auf der Leiterplatte (1) eine erste, elektrisch isolierende, vollflächige Schicht (3) und auf der ersten, elektrisch isolierenden Schicht (3) eine zweite, auf Masse liegende, elektrisch leitende, abschirmend wirkende Schicht (4) derart vollflächig aufgebracht wird, dass entsprechend der Anzahl von Bauelementen (2) geeignete Aussparungen (5) zur Aufnahme der Bauelemente vorgesehen werden.

2. Verfahren nach Anspruch 1,
**dadurch gekennzeichnet,**
**dass** es sich bei der ersten, elektrisch isolierenden Schicht (3) zusammen mit der zweiten, auf Masse liegenden, vollflächigen, elektrisch leitenden, abschirmend wirkenden Schicht (4) mit geeigneten Aussparungen zur Aufnahme der Bauelemente (5) entsprechend der Anzahl von Bauelementen (2) um eine HDI-Schicht handelt.

3. Kombination einer Leiterplatte (1), auf der mindestens eine elektrische Schaltung mit einer Anzahl von Bauelementen (2) realisiert ist, mit einer ersten, elektrisch isolierenden Schicht (3) und einer zweiten, auf Masse liegenden, vollflächigen, elektrisch leitenden, abschirmend wirkenden Schicht (4), wobei die erste, elektrisch isolierende Schicht (3) vollflächig auf der Leiterplatte (1) aufgebracht ist und auf der ersten, elektrisch isolierenden Schicht (3) die zweite, auf Masse liegende, elektrisch leitende, abschirmend wirkende Schicht (4) derart vollflächig aufgebracht ist, dass entsprechend der Anzahl von Bauelementen (2) geeignete Aussparungen zur Aufnahme der Bauelemente (5) vorgesehen sind.

## Claims

1. Method for shielding an electric circuit with a number of components (2) created on a printed circuit board (1), a first, electrically insulating, fully covering layer (3) being applied with full surface coverage to the printed circuit board (1) and a second, earthed, electrically conducting layer (4) with a shielding effect being applied with full surface coverage to the first, electrically insulating layer (3) in such a way that suitable clearances (5) corresponding to the number of components (2) are provided for receiving the components.

2. Method according to Claim 1, **characterized in that** the first, electrically insulating layer (3) together with the second, earthed, fully covering, electrically conducting layer (4) with a shielding effect, with suitable clearances corresponding to the number of components (2) for receiving the components (2), comprise an HDI layer.

3. Combination of a printed circuit board (1), on which at least one electric circuit with a number of components (2) is created, with a first, electrically insulating layer (3) and a second, earthed, fully covering, electrically conducting layer (4) with a shielding effect, the first, electrically insulating layer (3) being applied with full surface coverage to the printed circuit board (1) and the second, earthed, electrically conducting layer (4) with a shielding effect being applied with full surface coverage to the first, electrically insulating layer (3) in such a way that suitable clearances corresponding to the number of components (2) are provided for receiving the components (2).

## Revendications

1. Procédé de protection d'un circuit électrique réalisé sur une plaquette (1) à circuit imprimé et ayant un certain nombre de composants (2), dans lequel on dépose sur la plaquette (1) à circuit imprimé une première couche (3) isolante du point de vue électrique et sur toute la surface, et sur la première couche (3) isolante du point de vue électrique une deuxième couche (4) à la masse, conductrice de l'électricité et à effet protecteur sur toute la surface, de façon à prévoir, en fonction du nombre de composants (2), des évidements (5) appropriés de réception des composants.

2. Procédé suivant la revendication 1,
**caractérisé**
**en ce que** la première couche (3) électrique isolante du point de vue électrique, ensemble avec la deuxième couche (4) à la masse, sur toute la surface, conductrice de l'électricité et à effet de protection, ayant des évidements appropriés de réception des composants (5) correspondant au nombre de composants (2), est une couche HDI.

3. Combinaison d'une plaquette (1) à circuit imprimé sur laquelle est réalisé au moins un circuit électrique ayant un certain nombre de composants (2), comprenant une première couche (3) isolante du point de vue électrique et une deuxième couche (4) à la masse, sur toute la surface, conductrice de l'électricité et à effet de protection, la première couche (3) isolante du point de vue électrique étant déposée sur toute la surface sur la plaquette (1) à circuit imprimé et sur la première couche (3) isolante du point de vue électrique, la deuxième couche (4) à la masse, conductrice de l'électricité et à effet de protection est déposée sur toute la surface, de façon à ce qu'en fonction du nombre de composants (2), il soit prévu des évidements appropriés de réception des composants (5).
